(19) Europäisches Patentamt
European Patent Office
Office européen des brevets

(11) **EP 3 001 212 A1**

(12) **EUROPÄISCHE PATENTANMELDUNG**

(43) Veröffentlichungstag:
**30.03.2016 Patentblatt 2016/13**

(51) Int Cl.:
**G01R 33/48** *(2006.01)* **G01R 33/565** *(2006.01)*

(21) Anmeldenummer: **15185225.8**

(22) Anmeldetag: **15.09.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(30) Priorität: **24.09.2014 DE 102014219320**

(71) Anmelder: **Siemens Aktiengesellschaft**
**80333 München (DE)**

(72) Erfinder:
• **PAUL, Dominik**
  **91088 Bubenreuth (DE)**
• **SCHMITT, Benjamin**
  **Naremburn NSW, 2065 (AU)**

(54) **VERFAHREN UND MAGNETRESONANZANLAGE ZUR REKONSTRUKTION EINES MR-BILDES UNTER BERÜCKSICHTIGUNG DER CHEMISCHEN VERSCHIEBUNG**

(57) Die vorliegende Erfindung betrifft ein Verfahren und eine Magnetresonanzanlage (5) zur Rekonstruktion eines MR-Bildes (43) eines Volumenabschnitts innerhalb eines Untersuchungsobjekts (O). Dabei umfasst das Verfahren folgende Schritte: Erfassen von MR-Daten innerhalb des Volumenabschnitts gemäß einem Separationsverfahren, indem in einem Schritt jeweils die MR-Daten einer K-Raum-Zeile erfasst werden während ein Auslesegradient () jeweils entlang derselben Ausleserichtung geschaltet wird, mit dem Separationsverfahren ein Bild (41) eines ersten Stoffes und ein Bild (42) eines zweiten Stoffes zu rekonstruieren.

Bestimmen einer Verschiebungslänge (V), um welche das Bild (41) des ersten Stoffes und das Bild (42) des zweiten Stoffes aufgrund der chemischen Verschiebung entlang der Ausleserichtung relativ zueinander verschoben sind.

Verschieben des Bildes (41) des ersten Stoffes und/oder des Bildes (42) des zweiten Stoffes abhängig von der Verschiebungslänge (V), um die Verschiebung des Bildes (41) des ersten Stoffes gegenüber dem Bild (42) des zweiten Stoffes entlang der Ausleserichtung aufgrund der chemischen Verschiebung zu kompensieren.

Kombinieren des Bildes (41) des ersten Stoffes und des Bildes (42) des zweiten Stoffes, um das MR-Bild (43) zu erzeugen.

FIG 3

EP 3 001 212 A1

**Beschreibung**

Die vorliegende Erfindung betrifft ein Verfahren und eine Magnetresonanzanlage, um ein MR-Bild zu rekonstruieren, bei dessen Rekonstruktion die chemische Verschiebung berücksichtigt wird.

Beispielsweise bei der orthopädischen Bildgebung werden zur Diagnose MR-Bilder benötigt, bei welchen bei der Erstellung keine Fettunterdrückung eingesetzt wird. Darüber hinaus werden bei der orthopädischen Bildgebung eine hohe Auflösung und ein hohes Signal-Rausch-Verhältnis angestrebt, was nur durch eine hohe Feldstärke (z. B. drei Tesla und mehr) erreicht werden kann. Gerade bei hohen Feldstärken verursacht allerdings die chemische Verschiebung beispielsweise zwischen Fett und Wasser Artefakte (so genannte CSD-Artefakte ("Chemical Shift Displacement"), welche die Bildqualität und die Aussagekraft der erstellten MR-Bilder negativ beeinflussen.

Daher stellt sich die vorliegende Erfindung die Aufgabe, ein MR-Bild zu erstellen, in welchem mehrere Stoffe (beispielsweise Fett und Wasser) erkennbar sind und in welchem dennoch die Artefakte aufgrund der chemischen Verschiebung im Vergleich zum Stand der Technik zumindest abgemildert sind.

Erfindungsgemäß wird diese Aufgabe durch ein Verfahren zur Rekonstruktion eines MR-Bildes nach Anspruch 1, durch eine Magnetresonanzanlage nach Anspruch 12, durch ein Computerprogrammprodukt nach Anspruch 14 und durch einen elektronisch lesbaren Datenträger nach Anspruch 15 gelöst. Die abhängigen Ansprüche definieren bevorzugte und vorteilhafte Ausführungsformen der vorliegenden Erfindung.

Im Rahmen der vorliegenden Erfindung wird ein Verfahren zur Rekonstruktion eines MR-Bildes eines Volumenabschnitts innerhalb eines Untersuchungsobjekts mittels einer Magnetresonanzanlage bereitgestellt. Dabei umfasst das erfindungsgemäße Verfahren folgende Schritte:

- Erfassen von MR-Daten innerhalb des Volumenabschnitts gemäß einem Separationsverfahren. Dabei werden mehrfach in einem Schritt jeweils die MR-Daten einer K-Raum-Zeile erfasst während jeweils ein Auslesegradient entlang derselben Ausleserichtung geschaltet wird, um so den gesamten K-Raum abzutasten. Mit dem Separationsverfahren wird ausgehend von den erfassten MR-Daten sowohl ein Bild eines ersten Stoffes als auch ein Bild eines zweiten Stoffes rekonstruiert. Mit anderen Worten wird der K-Raum erfasst, indem der K-Raum-Zeile nach K-Raum-Zeile abgetastet wird, wobei jede K-Raum-Zeile und damit auch der jeweilige Auslesegradient immer in derselben Richtung bzw. parallel verlaufen. Durch den Einsatz des Separationsverfahrens wird dann aus den derart erfassten MR-Daten zum einen das Bild des ersten Stoffes und zum anderen das Bild des zweiten Stoffes rekonstruiert.
- Ermitteln einer Verschiebungslänge, um welche das Bild des ersten Stoffes und das Bild des zweiten Stoffes aufgrund der chemischen Verschiebung entlang der Ausleserichtung relativ zueinander verschoben sind. Mit anderen Worten entspricht die Verschiebungslänge einer Länge oder Strecke (gemessen in Bildpixeln), um welche das Bild des ersten (zweiten) Stoffes gegenüber dem Bild des zweiten (ersten) Stoffes verschoben ist.
- Verschieben des Bildes des ersten Stoffes und/oder des Bildes des zweiten Stoffes abhängig von der Verschiebungslänge, um dadurch die Verschiebung des Bildes des ersten Stoffes relativ zu dem Bild des zweiten Stoffes entlang der Ausleserichtung aufgrund der chemischen Verschiebung zu kompensieren oder rückgängig zu machen. Unter der Verschiebung eines ersten Bildes relativ zu einem zweiten Bild wird dabei verstanden, dass jedes Pixel des ersten Bildes relativ zu den Pixeln des zweiten Bildes verschoben wird.
- Kombinieren des Bildes des ersten Stoffes und des Bildes des zweiten Stoffes, um dadurch das MR-Bild zu erzeugen. Dabei wird unter einem Kombinieren von Bildern insbesondere eine Kombination (z.B. Addition) der entsprechenden bzw. übereinander liegenden Pixelwerte der Bilder verstanden.

Die vorliegende Erfindung kann beispielsweise eingesetzt werden, um ein MR-Bild zu erzeugen, in welchem sowohl Fett als auch Wasser abgebildet wird, ohne dass das erfindungsgemäß erzeugte MR-Bild aufgrund der chemischen Verschiebung verzerrt ist. Dadurch kann auch bei Magnetresonanzanlagen mit einer sehr hohen Feldstärke (z.B. 7 Tesla) und geringer Auslesebandbreite eine übliche Turbo-Spinecho-Sequenz zur Erfassung der MR-Daten eingesetzt werden, um MR-Bilder zu erzeugen, welche zum einen Fett und Wasser darstellen und zum anderen einen ausreichend guten Kontrast bieten, welcher für eine klinische Diagnose notwendig ist.

Bei der Definition der Verschiebungslänge gibt es zwei Möglichkeiten. Bei der ersten Möglichkeit ist die Verschiebungslänge als eine Länge definiert, um welche das Bild des ersten Stoffes gegenüber dem Bild des zweiten Stoffes entlang der Ausleserichtung verschoben ist. Bei der zweiten Möglichkeit ist die Verschiebungslänge als eine Länge (z.B. gemessen in einer Anzahl von Pixeln) definiert, um welche das Bild des zweiten Stoffes gegenüber dem Bild des ersten Stoffes entlang der Ausleserichtung verschoben ist.

Zur Kompensation der chemischen Verschiebung wird bei der ersten Möglichkeit das Bild des ersten Stoffes um x Prozent der negativen Verschiebungslänge gegenüber dem Bild des zweiten Stoffes verschoben und das Bild des zweiten Stoffes wird um (100 - x) Prozent der Verschiebungslänge gegenüber dem Bild des ersten Stoffes verschoben. Bevorzugt wird dabei x = 0 oder x = 100% gewählt werden, so dass nur das Bild des ersten Stoffes um die negative Verschiebungslänge gegenüber dem Bild des zweiten Stoffes oder nur das Bild des zweiten Stoffes um die Verschiebungslänge gegenüber dem Bild des ersten Stoffes verschoben wird.

In ähnlicher Weise werden zur Kompensation der chemischen Verschiebung bei der zweiten Möglichkeit das Bild des zweiten Stoffes um x Prozent der negativen Verschiebungslänge gegenüber dem Bild des ersten Stoffes und das Bild des ersten Stoffes um (100 - x) Prozent der Verschiebungslänge gegenüber dem Bild des zweiten Stoffes verschoben. Bevorzugt wird dabei x = 0 oder x = 100% gewählt werden, so dass nur das Bild des ersten Stoffes um die Verschiebungslänge gegenüber dem Bild des zweiten Stoffes oder nur das Bild des zweiten Stoffes um die negative Verschiebungslänge gegenüber dem Bild des ersten Stoffes verschoben wird.

Bei den Stoffen kann es sich beispielsweise um Wasser, Fett und/oder Silikon handeln. Darüber hinaus kann die vorliegende Erfindung auch zur Darstellung von Fluor-Komponenten, welche mehrere Resonanzfrequenzen besitzen, eingesetzt werden. In diesem Fall wird die Fluor-Komponente mit der ersten Resonanzfrequenz als erster Stoff und die Fluor-Komponente mit der zweiten Resonanzfrequenz als zweiter Stoff angesehen.

Gemäß einer bevorzugten erfindungsgemäßen Ausführungsform wird im Schritt des Erfassens von MR-Daten keine selektive Anregung eingesetzt. Mit anderen Worten wird zur Erfassung der MR-Daten beim Einstrahlen des HF-Anregungspulses kein Schichtselektionsgradient geschaltet. Zur Erfassung der jeweiligen K-Raum-Zeile werden daher insbesondere zwei Phasenkodiergradienten geschaltet, wobei die beiden Phasenkodiergradienten und der Auslesegradient wechselseitig aufeinander senkrecht stehen.

Der Vorteil dieser Ausführungsform besteht darin, dass aufgrund des nicht vorhandenen Schichtselektionsgradienten keine chemische Verschiebung in Schichtselektionsrichtung auftritt. Auch wenn quasi anstelle des Schichtselektionsgradienten ein Phasenkodiergradient in Schichtselektionsrichtung eingesetzt wird, verursacht letztgenannter im Vergleich zu einer Schichtselektion keine chemische Verschiebung. Bei dieser Ausführungsform kann der Fall, dass durch die HF-Anregung quasi zwei unterschiedliche Schichten im Raum für Fett und Wasser angeregt werden nicht auftreten. Daher ist auch der nach dem Stand der Technik bei starken Feldstärken auftretende Fall, dass Fett quasi außerhalb des Untersuchungsobjekts lokalisiert wird, so dass das sich ergebende MR-Bild einen so genannten Fettsättigungs-Kontrast aufzuweisen scheint, obwohl der Benutzer keine Fettsättigung erwünschte und das Protokoll auch entsprechend festgelegt hat, nicht möglich.

Zum Erfassen der MR-Daten kann sowohl eine Gradientenecho-Sequenz als auch eine Spinecho-Sequenz eingesetzt werden.

Eine Spinecho-Sequenz kann dabei folgende Unterschritte umfassen:

- Einstrahlen eines nicht selektiven HF-Anregungspulses. Beim Einstrahlen des nicht selektiven HF-Anregungspulses wird demnach kein Schichtselektionsgradient geschaltet.
- Einstrahlen eines nicht selektiven Refokussierungspulses. Auch beim Einstrahlen des nicht selektiven Refokussierungspulses wird kein Gradient (Schichtselektionsgradient) geschaltet.
- Anlegen eines ersten Phasenkodiergradienten entlang einer ersten Richtung, welche beispielsweise einer Schichtselektionsrichtung entsprechen kann.
- Anlegen eines zweiten Phasenkodiergradienten entlang einer zweiten Richtung, welche senkrecht zu der ersten Richtung angeordnet ist.
- Erfassen der MR-Daten einer K-Raum-Zeile während der Auslesegradient geschaltet ist. Dabei steht die Ausleserichtung (Richtung, entlang welcher der Auslesegradient geschaltet wird) sowohl senkrecht auf der ersten Richtung als auch auf der zweiten Richtung.

Alle Unterschritte bis auf den ersten Unterschritt (Einstrahlen des nicht selektiven HF-Anregungspulses) werden mehrfach ausgeführt, so dass ausgehend von demselben HF-Anregungspuls die MR-Daten mehrerer K-Raum-Zeilen erfasst werden. Die Anzahl der mit demselben HF-Anregungspuls erfassten K-Raum-Zeilen ist auch als Echozuglänge bekannt.

Die Verschiebungslänge kann abhängig von der Feldstärke der Magnetresonanzanlage, einer Auslesebandbreite und der chemischen Verschiebung der Resonanzfrequenz des ersten Stoffes gegenüber der Resonanzfrequenz des zweiten Stoffes bestimmt werden.

Beispielsweise kann die Verschiebungslänge V definiert durch eine Anzahl von Bildpixeln durch folgende Gleichung (1) bestimmt werden.

$$V = \frac{\gamma \times \delta \times FS \times AP}{ABB} \qquad (1)$$

Dabei entspricht $\gamma$ dem gyromagnetischen Verhältnis, $\delta$ einem dimensionslosen Parameter, welcher die chemische Verschiebung repräsentiert, FS der Feldstärke der Magnetresonanzanlage, AP einer Anzahl von Pixeln, welche pro K-Raum-Zeile abgetastet werden, und ABB der Auslesebandbreite. δ wird gemäß der folgenden Gleichung (2) bestimmt.

$$\delta[ppm] = \frac{f_1 - f_2}{f_2} \times 10^6 \qquad (2).$$

Dabei entspricht f1 der Resonanzfrequenz des ersten Stoffes und f2 der Resonanzfrequenz des zweiten Stoffes.

Bei einer Feldstärke von 1,5 Tesla, einer Auslesebandbreite von 32 kHz und einer Anzahl von 256 Pixel pro K-Raum-Zeile entspricht die Verschiebungslänge V bei einer chemischen Verschiebung zwischen Fett und Wasser von 3,5 ppm beispielsweise 1,76 Pixel. Bei diesem Beispiel wird demnach jedes Pixel des Fettsignal-Bilds (Bild des ersten Stoffes) um 1,76 Pixel entlang der Ausleserichtung gegenüber dem Wassersignal-Bild (Bild des zweiten Stoffes) verschoben, bevor das Fettsignal-Bild mit dem Wassersignal-Bild kombiniert wird.

Bisher wurde die Erfindung nur hinsichtlich zwei Stoffen beschrieben. Es ist allerdings auch möglich, die vorliegende Erfindung einzusetzen, um die chemische Verschiebung bezüglich mehr als zwei Stoffen zu korrigieren. Dazu werden aus den MR-Daten N Bilder rekonstruiert, wobei N > 2 ist. In jedem der N Bilder ist im Wesentlichen ein anderer von N Stoffen abgebildet bzw. dargestellt. Für jedes dieser N Bilder wird eine individuelle Verschiebungslänge bestimmt, um welche das jeweilige Bild gegenüber einem bestimmten der N Bilder aufgrund der chemischen Verschiebung entlang der Ausleserichtung verschoben ist. Abhängig von dieser individuellen Verschiebungslänge wird jedes der N Bilder gegenüber dem bestimmten Bild entlang der Ausleserichtung verschoben, umso die Verschiebung des jeweiligen Bildes gegenüber dem bestimmten Bild entlang der Ausleserichtung aufgrund der chemischen Verschiebung zu kompensieren oder rückgängig zu machen. Anschließend werden alle N Bilder kombiniert, um das MR-Bild zu erzeugen.

Durch die vorab beschriebene Erweiterung der vorliegenden Erfindung auf mehr als zwei Stoffe kann beispielsweise ein MR-Bild erzeugt werden, in welchem neben Fett und Wasser auch Silikon dargestellt ist, ohne dass das MR-Bild aufgrund der chemischen Verschiebung in der Ausleserichtung verfälscht ist. Darüber hinaus kann die vorliegende Erfindung auch eingesetzt werden, um ein MR-Bild von Stoffgemischen zu erzeugen, wobei ein solches Stoffgemisch aus Stoffen mit unterschiedlichen Resonanzfrequenzen besteht. Beispielsweise weisen bestimmte Fluor-Komponenten mehrere unterschiedliche Resonanzfrequenzen auf. Erfindungsgemäß würden solche Fluor-Komponenten als ein Stoffgemisch interpretiert werden, welches Stoffe mit den unterschiedlichen Resonanzfrequenzen umfasst. Für jede Resonanzfrequenz wird ein Bild erstellt. Anschließend werden die Bilder wie oben beschrieben relativ zueinander verschoben, um die chemische Verschiebung entlang der Ausleserichtung zu kompensieren, bevor die Bilder dann zu einem MR-Bild kombiniert werden, welches die Fluor-Komponenten ohne CSD-Effekt in dem erzeugten MR-Bild darstellt.

Separationsverfahren oder Bildgebungsverfahren, welche die Rekonstruktion des Bildes des ersten Stoffes und des Bildes des zweiten Stoffes (oder die Rekonstruktion von N Bildern, welche jeweils im Wesentlichen einen von N Stoffen darstellen) ermöglichen, werden spektroskopische Bildgebung ("spectroscopic imaging") oder Bildgebung zur chemischen Verschiebung ("chemical shift imaging") genannt. Einige dieser Separationsverfahren oder Bildgebungsverfahren basieren auf der so genannten Dixon-Methode (siehe z.B. "Handbook of MRI Pulse Sequences", M.A. Bernstein u.a., ISBN-13: 978-0-12-092861-3, Kapitel 17.3. Dixon's Method). Ein Separationsverfahren speziell zur Erstellung von mehreren Bildern unterschiedlicher Stoffe bzw. unterschiedlicher Resonanzfrequenzen ist beispielweise 2001 in "Chemical shift imaging with spectrum modeling", von L. An und Q. Xing, in Magn.Reson.Med. 46, Seiten 126-130 beschrieben worden.

Im Rahmen der vorliegenden Erfindung wird auch eine Magnetresonanzanlage zur Erfassung von MR-Daten eines Volumenabschnitts innerhalb eines Untersuchungsobjekts bereitgestellt. Dabei umfasst die Magnetresonanzanlage einen Grundfeldmagneten, ein Gradientenfeldsystem, eine oder mehrere HF-Antennen und eine Steuereinrichtung zur Ansteuerung des Gradientenfeldsystems und der HF-Antenne(n), zum Empfang der Messsignale, welche von der/den HF-Antenne(n) aufgenommen werden, und zur Auswertung der Messsignale sowie zur Erstellung der MR-Daten. Die Magnetresonanzanlage ist derart ausgestaltet, dass die Magnetresonanzanlage MR-Daten innerhalb des Volumenabschnitts gemäß einem Separationsverfahren erfasst, indem die Magnetresonanzanlage jeweils in einem Schritt die MR-Daten einer gesamten K-Raum-Zeile erfasst während mittels des Gradientenfeldsystems ein Auslesegradient jeweils entlang derselben Ausleserichtung geschaltet wird. Mit Hilfe des Separationsverfahrens rekonstruiert die Steuereinrichtung aus den MR-Daten ein Bild eines ersten Stoffes und ein Bild eines zweiten Stoffes. Die Steuereinrichtung, insbesondere der Anlagenrechner der Steuereinrichtung der Magnetresonanzanlage, bestimmt eine Verschiebungslänge, um welche das Bild des ersten Stoffes und das Bild des zweiten Stoffes aufgrund der chemischen Verschiebung entlang der Ausleserichtung relativ zueinander verschoben sind. Ausgehend von dieser Verschiebungslänge verschiebt die Steuereinrichtung das Bild des ersten Stoffes und/oder das Bild des zweiten Stoffes, um die Verschiebung des Bildes des ersten Stoffes relativ zu dem Bild des zweiten Stoffes entlang der Ausleserichtung aufgrund der chemischen Verschiebung zu kompensieren oder rückgängig zu machen. Schließlich kombiniert die Steuereinrichtung das Bild des ersten Stoffes und das Bild des zweiten Stoffes, um das MR-Bild zu erzeugen.

Die Vorteile der erfindungsgemäßen Magnetresonanzanlage entsprechen im Wesentlichen den Vorteilen des erfindungsgemäßen Verfahrens, welche vorab im Detail beschrieben worden sind, so dass hier auf eine Wiederholung verzichtet wird.

Des Weiteren beschreibt die vorliegende Erfindung ein Computerprogrammprodukt, insbesondere eine Software, welche man in einen Speicher einer programmierbaren Steuereinrichtung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuereinrichtung läuft. Dabei benötigt das Computerprogrammprodukt eventuell Programmmittel, z.B. Bibliotheken und Hilfsfunktionen, um die entsprechenden Ausführungsformen des Verfahrens zu realisieren. Mit anderen Worten soll mit dem auf das Computerprogrammprodukt gerichteten Anspruch insbesondere eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert und gebunden oder der nur interpretiert werden muss, oder um einen ausführbaren Softwarecode handeln, der zur Ausführung nur noch in die entsprechende Recheneinheit bzw. Steuereinrichtung zu laden ist.

Schließlich offenbart die vorliegende Erfindung einen elektronisch lesbaren Datenträger, z.B. eine DVD, ein Magnetband, eine Festplatte oder einen USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuereinrichtung bzw. Recheneinheit einer Magnetresonanzanlage gespeichert werden, können alle erfindungsgemäßen Ausführungsformen des vorab beschriebenen Verfahrens durchgeführt werden.

Mit der vorliegenden Erfindung können MR-Bilder erzeugt werden, in welchen unterschiedliche Stoffe, welche unterschiedliche Resonanzfrequenzen aufweisen, ortsrichtig zueinander dargestellt werden.

Die Erfindung ermöglicht die Erstellung von MR-Bildern, welche Fett und Wasser kombiniert darstellen, wobei eine PD (Protonendichte) gewichtete Bildgebung mit minimaler oder auch längerer Echozeit und sogar eine T2 gewichtete Bildgebung eingesetzt werden kann. Dabei kann entweder eine zweidimensionale Spinecho-Sequenz oder eine Turbo-Spinecho-Sequenz eingesetzt werden.

Im Folgenden wird die vorliegende Erfindung anhand erfindungsgemäßer Ausführungsformen mit Bezug zu den Figuren im Detail beschrieben.

Fig. 1 stellt eine erfindungsgemäße Magnetresonanzanlage dar.

In Fig. 2 ist schematisch ein reales Objekt dargestellt, welches einen Fettanteil und einen Wasseranteil aufweist.

In Fig. 3 sind ein Wassersignal-Bild und ein Fettsignal-Bild übereinander dargestellt.

In Fig. 4 ist ein erfindungsgemäß erzeugtes MR-Bild des in Fig. 2 abgebildeten Objektes dargestellt.

In Fig. 5 ist eine erfindungsgemäße Turbo-Spinecho-Sequenz dargestellt.

In Fig. 6 ist der Flussplan eines erfindungsgemäßen Verfahrens zur Rekonstruktion eines MR-Bildes dargestellt.

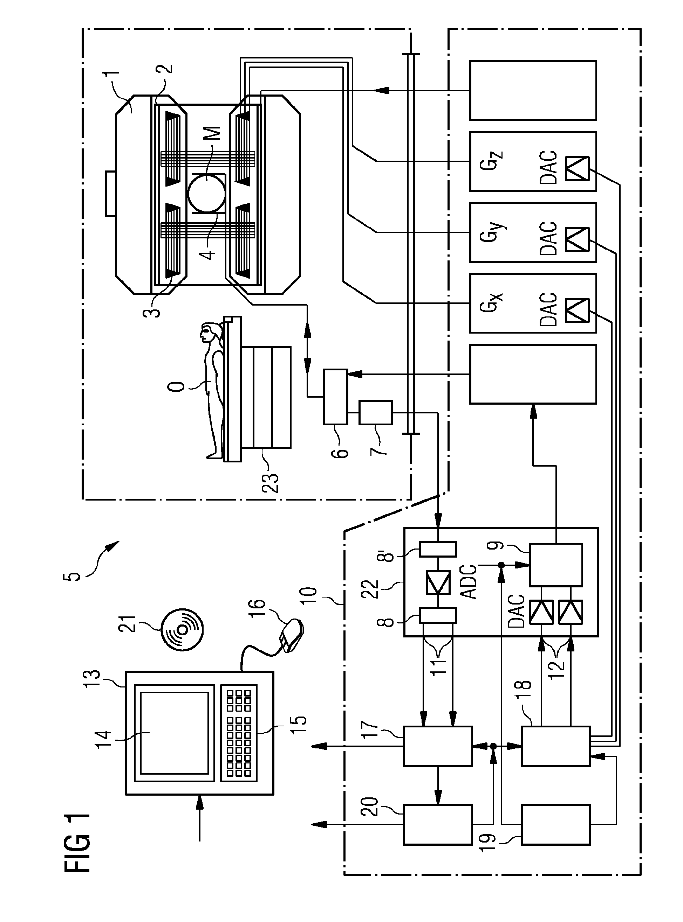

Fig. 1 zeigt eine schematische Darstellung einer erfindungsgemäßen Magnetresonanzanlage 5 (eines Magnetresonanz-Bildgebungs- bzw. Kernspintomographiegeräts). Dabei erzeugt ein Grundfeldmagnet 1 ein zeitlich konstantes starkes Magnetfeld zur Polarisation bzw. Ausrichtung der Kernspins in einem Untersuchungsbereich eines Objekts O, wie z.B. eines zu untersuchenden Teils eines menschlichen Körpers, welcher auf einem Tisch 23 liegend kontinuierlich in die Magnetresonanzanlage 5 geschoben wird. Die für die Kernspinresonanzmessung erforderliche hohe Homogenität des Grundmagnetfelds ist in einem typischerweise kugelförmigen Messvolumen M definiert, in welchem die zu untersuchenden Teile des menschlichen Körpers bevorzugt gemessen werden. Zur Unterstützung der Homogenitätsanforderungen und insbesondere zur Eliminierung zeitlich invariabler Einflüsse werden an geeigneter Stelle so genannte Shim-Bleche aus ferromagnetischem Material angebracht. Zeitlich variable Einflüsse werden durch Shim-Spulen 2 eliminiert.

In den Grundfeldmagneten 1 ist ein zylinderförmiges Gradientenfeldsystem bzw. Gradientenfeldsystem 3 eingesetzt, welches aus drei Teilwicklungen besteht. Jede Teilwicklung wird von einem Verstärker mit Strom zur Erzeugung eines linearen (auch zeitlich veränderbaren) Gradientenfeldes in die jeweilige Richtung des kartesischen Koordinatensystems versorgt. Die erste Teilwicklung des Gradientenfeldsystems 3 erzeugt dabei einen Gradienten $G_x$ in x-Richtung, die zweite Teilwicklung einen Gradienten $G_y$ in y-Richtung und die dritte Teilwicklung einen Gradienten $G_z$ in z-Richtung. Der Verstärker umfasst einen Digital-Analog-Wandler, welcher von einer Sequenzsteuerung 18 zum zeitrichtigen Erzeugen von Gradientenpulsen angesteuert wird.

Innerhalb des Gradientenfeldsystems 3 befindet sich eine (oder mehrere) Hochfrequenzantennen 4, welche die von einem Hochfrequenzleistungsverstärker abgegebenen Hochfrequenzpulse in ein magnetisches Wechselfeld zur Anregung der Kerne und Ausrichtung der Kernspins des zu untersuchenden Objekts O bzw. des zu untersuchenden Bereiches des Objekts O umsetzen. Jede Hochfrequenzantenne 4 besteht aus einer oder mehreren HF-Sendespulen und einer oder mehreren HF-Empfangsspulen in Form einer ringförmigen vorzugsweise linearen oder matrixförmigen Anordnung von Komponentenspulen. Von den HF-Empfangsspulen der jeweiligen Hochfrequenzantenne 4 wird auch das von den präzedierenden Kernspins ausgehende Wechselfeld, d.h. in der Regel die von einer Pulssequenz aus einem oder mehreren Hochfrequenzpulsen und einem oder mehreren Gradientenpulsen hervorgerufenen Kernspinechosignale, in eine Spannung (Messsignal) umgesetzt, welche über einen Verstärker 7 einem Hochfrequenz-Empfangskanal 8 eines Hochfrequenzsystems 22 zugeführt wird. Das Hochfrequenzsystem 22, welches Teil einer Steuereinrichtung 10 der Magnetresonanzanlage 5 ist, umfasst weiterhin einen Sendekanal 9, in welchem die Hochfrequenzpulse für die Anregung der magnetischen Kernresonanz erzeugt werden. Dabei werden die jeweiligen Hochfrequenzpulse aufgrund einer vom Anlagerechner 20 vorgegebenen Pulssequenz in der Sequenzsteuerung 18 digital als Folge komplexer Zahlen dargestellt. Diese Zahlenfolge wird als Real- und als Imaginärteil über jeweils einen Eingang 12 einem Digital-Analog-Wandler im Hochfrequenzsystem 22 und von diesem einem Sendekanal 9 zugeführt. Im Sendekanal 9 werden die Pulssequenzen einem Hochfrequenz-Trägersignal aufmoduliert, dessen Basisfrequenz der Resonanzfrequenz der Kernspins im Messvolumen entspricht.

Die Umschaltung von Sende- auf Empfangsbetrieb erfolgt über eine Sende-Empfangsweiche 6. Die HF-Sendespulen der Hochfrequenzantenne(n) 4 strahlt/en die Hochfrequenzpulse zur Anregung der Kernspins in das Messvolumen M ein und resultierende Echosignale werden über die HF-Empfangsspule(n) abgetastet. Die entsprechend gewonnenen Kernresonanzsignale werden im Empfangskanal 8' (erster Demodulator) des Hochfrequenzsystems 22 phasenempfindlich auf eine Zwischenfrequenz demoduliert, im Analog-Digital-Wandler (ADC) digitalisiert und über den Ausgang 11 ausgegeben. Dieses Signal wird noch auf die Frequenz 0 demoduliert. Die Demodulation auf die Frequenz 0 und die Trennung in Real- und Imaginärteil findet nach der Digitalisierung in der digitalen Domäne in einem zweiten Demodulator 8 statt. Durch einen Bildrechner 17 wird aus den dergestalt über einen Ausgang 11 gewonnenen Messdaten ein MR-Bild rekonstruiert. Die Verwaltung der Messdaten, der Bilddaten und der Steuerprogramme erfolgt über den Anlagenrechner 20. Aufgrund einer Vorgabe mit Steuerprogrammen kontrolliert die Sequenzsteuerung 18 die Erzeugung der jeweils gewünschten Pulssequenzen und das entsprechende Abtasten des k-Raumes. Insbesondere steuert die Sequenzsteuerung 18 dabei das zeitrichtige Schalten der Gradienten, das Aussenden der Hochfrequenzpulse mit definierter Phasenamplitude (einschließlich von Refokussierungspulsen) sowie den Empfang der Kernresonanzsignale. Die erfindungsgemäße Sequenzsteuerung 18 ist ausgestaltet, um die MR-Daten gemäß einem Separationsverfahren (z.B. der Dixon-Methode) K-Raum-Zeile für K-Raum-Zeile zu erfassen, wobei alle K-Raum-Zeilen parallel verlaufen. Der erfindungsgemäße Bildrechner 17 rekonstruiert zuerst aus den MR-Daten gemäß dem Separationsverfahren ein Bild eines ersten Stoffes und ein Bild eines zweiten Stoffes, bevor der Bildrechner 17 zumindest eines der beiden Bilder entsprechend einer Verschiebungslänge verschiebt und anschließend die beiden Bilder kombiniert, um ein kombiniertes MR-Bild zu erzeugen, welches beide Stoffe ortsgenau abbildet. Die Verschiebungslänge wird insbesondere abhängig von der Resonanzfrequenz der beiden Stoffe von dem erfindungsgemäßen Anlagenrechner 20 errechnet. Die Zeitbasis für das Hochfrequenzsystem 22 und die Sequenzsteuerung 18 wird von einem Synthesizer 19 zur Verfügung gestellt. Die Auswahl entsprechender Steuerprogramme zur Erzeugung eines MR-Bildes, welche z.B. auf einer DVD 21 gespeichert sind, sowie die Darstellung des erzeugten MR-Bildes erfolgt über ein Terminal 13, welches eine Tastatur 15, eine Maus 16 und einen Bildschirm 14 umfasst.

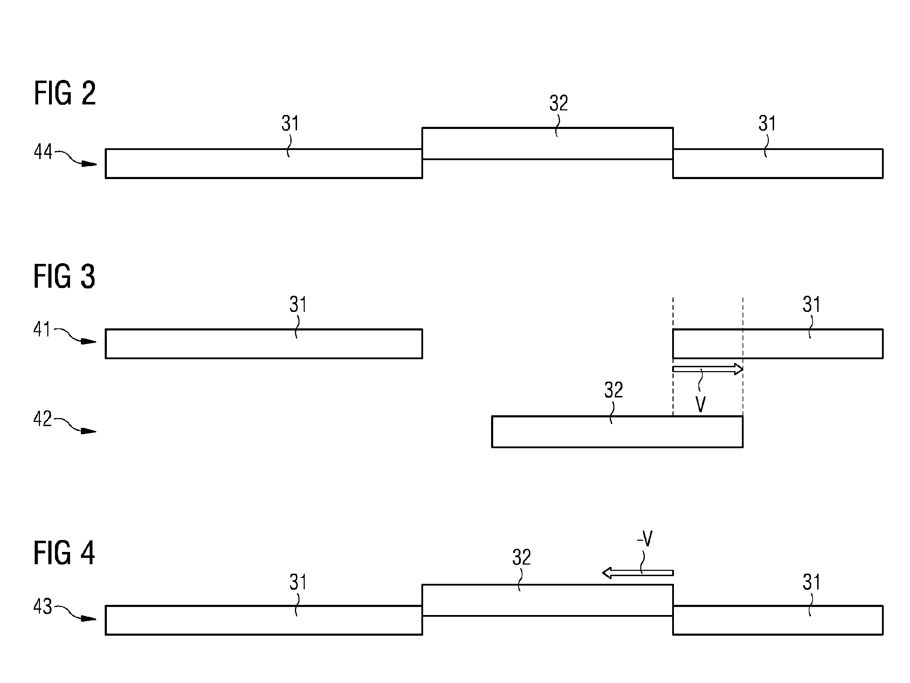

In Fig. 2 ist schematisch die Situation eines realen Untersuchungsobjektes dargestellt, welches Wasser 31 und Fett 32 aufweist.

Erfindungsgemäß werden MR-Daten eines Volumenabschnitts dieses Untersuchungsobjektes gemäß der Dixon-Methode erfasst. Anschließend wird anhand der Dixon-Methode ein Wassersignal-Bild 41 (Bild eines ersten Stoffes) und ein Fettsignal-Bild 42 (Bild eines zweiten Stoffes) aus den vorher erfassten MR-Daten rekonstruiert. Man erkennt, dass die Fett-Pixel 32 gegenüber den Wasser-Pixeln 31 um eine Verschiebungslänge V verschoben sind. Anders ausgedrückt ist das Fettsignal-Bild 42 um die Verschiebungslänge V (gemessen in Pixeln) gegenüber dem Wassersignal-Bild 41 verschoben.

Erfindungsgemäß wird diese Verschiebung V kompensiert oder rückgängig gemacht, indem entweder das Fettsignal-Bild 42 um die negative Verschiebungslänge -V (d.h. in negativer Richtung um die entsprechende Pixelanzahl) verschoben wird, wie es in Fig. 4 dargestellt ist, oder indem das Wassersignal-Bild 31 um die positive Verschiebungslänge V (d.h. in positiver Richtung um die entsprechende Pixelanzahl) verschoben wird. Nach dieser Verschiebung werden die beiden Bilder 41, 42 kombiniert, wodurch sich das MR-Bild bzw. Fett-Wasser-Bild 43 ergibt.

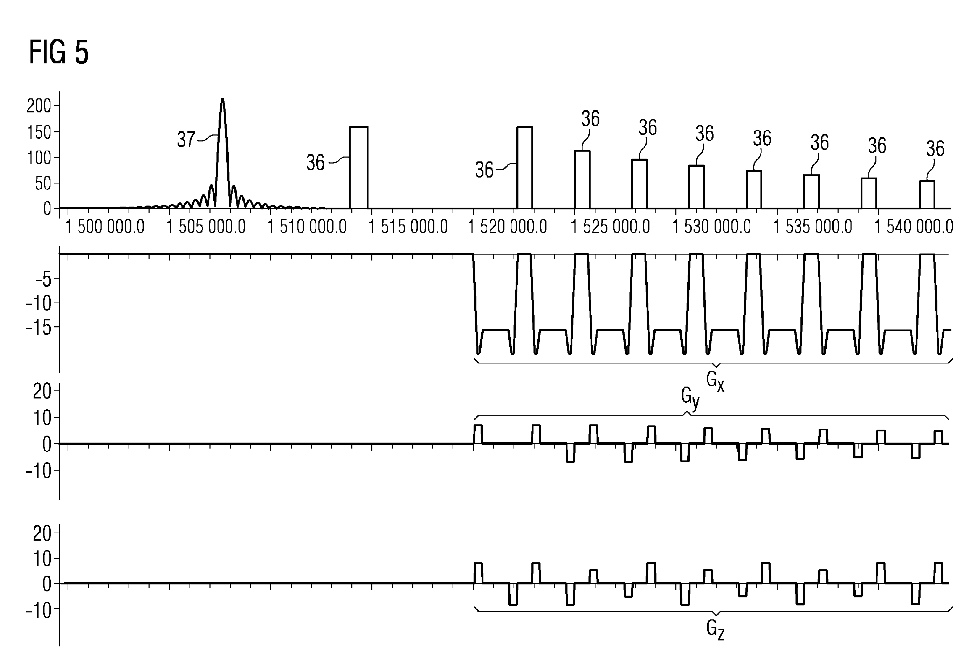

In Fig. 5 ist eine erfindungsgemäße Sequenz zum Erfassen der MR-Daten dargestellt.

Die Sequenz beginnt, indem ein nicht selektiver HF-Anregungspuls 37 eingestrahlt wird. Anschließend wird ein nicht selektiver Refokussierungspuls 36 eingestrahlt, bevor mit einem ersten Phasenkodiergradienten $G_z$ und einem zweiten Phasenkodiergradienten $G_y$ zu einer bestimmten K-Raum-Zeile navigiert wird, welche dann mit Hilfe eines Auslesegradienten $G_x$ ausgelesen wird. Indem weitere Refokussierungspulse 36 eingestrahlt und weitere erste Phasenkodiergradienten $G_z$ sowie weitere zweite Phasenkodiergradienten $G_y$ geschaltet werden, werden mit Hilfe weiterer Auslesegradienten $G_x$ weitere K-Raum-Zeilen ausgelesen, bevor ein weiterer nicht selektiver HF-Anregungspuls 37 eingestrahlt wird.

Da die in Fig. 5 dargestellte Sequenz keinen Schichtselektionsgradienten (weder für den HF Anregungspuls 37 noch für den Refokussierungspuls 36) aufweist, tritt vorteilhafterweise der CSD-Effekt weder beim Einstrahlen des HF-Anregungspulses 37 noch beim Einstrahlen des Refokussierungspulses 36 auf. Darüber hinaus erkennt man in der Fig. 5, dass der Auslesegradient $G_x$ ein größeres Gradientenmoment aufweist, als der erste Phasenkodiergradient $G_z$ oder der zweite Phasenkodiergradient $G_y$. Aus diesem Grund werden die CSD-Effekte im Wesentlichen von dem Auslesegradienten $G_x$ verursacht. Erfindungsgemäß werden nun genau diese CSD-Effekte entlang dem Auslesegradienten $G_x$ kompensiert, indem das Wassersignal-Bild 41 und das Fettsignal-Bild 42 entsprechend der Verschiebungslänge V gegeneinander verschoben werden, bevor die beiden Bilder 41, 42 zum MR-Bild 43 kombiniert werden.

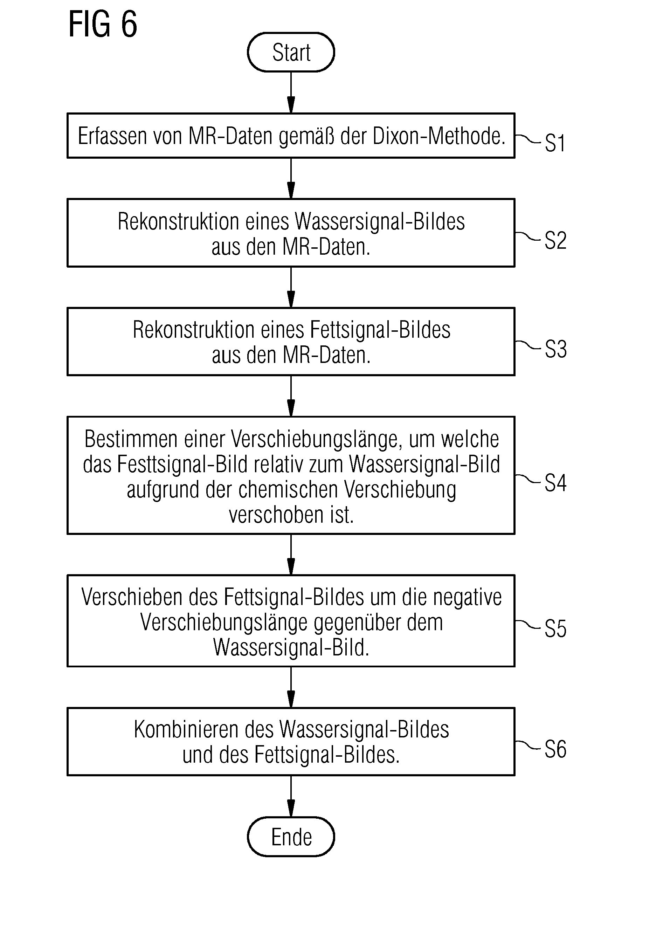

In Fig. 6 ist der Flussplan eines erfindungsgemäßen Verfahrens zur Rekonstruktion eines MR-Bildes 43 abgebildet.

Im Schritt S1 werden MR-Daten des vorbestimmten Volumenabschnitts des Untersuchungsobjekts gemäß der Dixon-Methode erfasst. An dieser Stelle sei darauf hingewiesen, dass die Dixon-Methode sowohl mit Spinecho-Sequenzen als auch mit Gradientenecho-Sequenzen arbeiten kann. Im Schritt S2 wird gemäß der Dixon-Methode aus den MR-Daten ein Wassersignal-Bild 41 und im Schritt S3 ein Fettsignal-Bild 42 rekonstruiert.

Im Schritt S4 wird eine Verschiebungslänge V bestimmt, um welche das Fettsignal-Bild 42 gegenüber dem Wassersignal-Bild 41 aufgrund der chemischen Verschiebung entlang der Ausleserichtung verschoben ist. Im Schritt S5 wird das Fettsignal-Bild 42 um die negative Verschiebungslänge V gegenüber dem Wassersignal-Bild 41 verschoben, um die CSD-Effekte entlang der Ausleserichtung zu kompensieren. Schließlich wird im Schritt S6 das Wassersignal-Bild 41 mit dem Fettsignal-Bild 42 kombiniert, woraus sich das zu erzeugende MR-Bild 43 ergibt.

**Patentansprüche**

1. Verfahren zur Rekonstruktion eines MR-Bildes (43) eines Volumenabschnitts innerhalb eines Untersuchungsobjektes (O) mittels einer Magnetresonanzanlage (5), wobei das Verfahren folgende Schritte umfasst:

   Erfassen von MR-Daten innerhalb des Volumenabschnitts gemäß einem Separationsverfahren, indem in einem Schritt jeweils die MR-Daten einer K-Raum-Zeile erfasst werden während ein Auslesegradient ($G_x$) jeweils entlang derselben Ausleserichtung geschaltet wird, um mit dem Separationsverfahren ein Bild (41) eines ersten Stoffes und ein Bild (42) eines zweiten Stoffes zu rekonstruieren,
   Bestimmen einer Verschiebungslänge (V), um welche das Bild (41) des ersten Stoffes und das Bild (42) des zweiten Stoffes aufgrund der chemischen Verschiebung entlang der Ausleserichtung relativ zueinander verschoben sind,
   Verschieben des Bildes (41) des ersten Stoffes und/oder des Bildes (42) des zweiten Stoffes abhängig von der Verschiebungslänge (V), um die Verschiebung des Bildes (41) des ersten Stoffes gegenüber dem Bild (42) des zweiten Stoffes entlang der Ausleserichtung aufgrund der chemischen Verschiebung zu kompensieren, und
   Kombinieren des Bildes (41) des ersten Stoffes und des Bildes (42) des zweiten Stoffes, um das MR-Bild (43) zu erzeugen.

2. Verfahren nach Anspruch 1,
   **dadurch gekennzeichnet,**
   **dass** die Verschiebungslänge (V) eine Länge definiert, um welche das Bild (41) des ersten Stoffes gegenüber dem Bild (42) des zweiten Stoffes entlang der Ausleserichtung verschoben ist,
   **dass** das Bild (41) des ersten Stoffes um x Prozent der negativen Verschiebungslänge (V) verschoben wird, und
   **dass** das Bild (42) des zweiten Stoffes um (100 - x) Prozent der Verschiebungslänge (V) verschoben wird, oder
   **dass** die Verschiebungslänge eine Länge definiert, um welche das Bild (42) des zweiten Stoffes gegenüber dem Bild (41) des ersten Stoffes entlang der Ausleserichtung verschoben ist,
   **dass** das Bild (42) des zweiten Stoffes um x Prozent der negativen Verschiebungslänge verschoben wird, und
   **dass** das Bild (41) des ersten Stoffes um (100 - x) Prozent der Verschiebungslänge verschoben wird,
   wobei $0 \leq x \leq 100$ gilt.

3. Verfahren nach Anspruch 1 oder 2,
   **dadurch gekennzeichnet,**
   **dass** der erste Stoff Wasser und der zweite Stoff Fett ist.

4. Verfahren nach einem der vorhergehenden Ansprüche,
   **dadurch gekennzeichnet,**
   **dass** in dem Schritt des Erfassens der MR-Daten keine selektive Anregung eingesetzt wird.

**5.** Verfahren nach einem der vorhergehenden Ansprüche,
**dadurch gekennzeichnet,**
**dass** in dem Schritt des Erfassens der MR-Daten eine Gradientenecho-Sequenz eingesetzt wird.

**6.** Verfahren nach einem der Ansprüche 1-4,
**dadurch gekennzeichnet,**
**dass** in dem Schritt des Erfassens der MR-Daten eine Spinecho-Sequenz eingesetzt wird.

**7.** Verfahren nach Anspruch 6,
**dadurch gekennzeichnet,**
**dass** der Schritt des Erfassens der MR-Daten folgende Unterschritte umfasst:

Einstrahlen eines nicht selektiven HF-Anregungspulses (37), wobei dabei kein Gradient geschaltet ist,
Einstrahlen eines nicht selektiven Refokussierungspulses (36), wobei dabei kein Gradient geschaltet ist,
Anlegen eines ersten Phasenkodiergradienten ($G_z$) entlang einer ersten Richtung,
Anlegen eines zweiten Phasenkodiergradienten ($G_y$) entlang einer zweiten Richtung, welche senkrecht zu der ersten Richtung angeordnet ist,
Erfassen der MR-Daten einer K-Raum-Zeile während der Auslesegradient ($G_x$) geschaltet ist, wobei die Ausleserichtung sowohl senkrecht zu der ersten Richtung als auch senkrecht zu der zweiten Richtung angeordnet ist,
wobei alle Unterschritte bis auf das Einstrahlen des HF-Anregungspulses (37) mehrfach ausgeführt werden, um ausgehend von demselben HF-Anregungspuls (37) die MR-Daten mehrerer K-Raum-Zeilen zu erfassen.

**8.** Verfahren nach einem der vorhergehenden Ansprüche,
**dadurch gekennzeichnet,**
**dass** die Verschiebungslänge (V) abhängig von einer Feldstärke der Magnetresonanzanlage (5), einer Auslesebandbreite und der chemischen Verschiebung der Resonanzfrequenz des ersten Stoffes gegenüber der Resonanzfrequenz des zweiten Stoffes bestimmt wird.

**9.** Verfahren nach Anspruch 8,
**dadurch gekennzeichnet,**
**dass** die Verschiebungslänge V in Anzahl von Bildpixeln durch folgende Gleichung bestimmt wird

$$V = \frac{\gamma \times \delta \times FS \times AP}{ABB},$$

wobei $\gamma$ dem gyromagnetischen Verhältnis entspricht, wobei FS der Feldstärke der Magnetresonanzanlage (5) entspricht, wobei AP einer Anzahl von Pixeln pro K-Raum-Zeile entspricht, wobei ABB der Auslesebandbreite entspricht, und wobei die chemische Verschiebung mit dem dimensionslosen Parameter $\delta$ gemäß folgender Gleichung beschrieben wird

$$\delta[ppm] = \frac{f_1 - f_2}{f_2} \times 10^6,$$

wobei $f_1$ der Resonanzfrequenz des ersten Stoffes und $f_2$ der Resonanzfrequenz des zweiten Stoffes entspricht.

**10.** Verfahren nach einem der vorhergehenden Ansprüche,
**dadurch gekennzeichnet,**
**dass** gemäß dem Separationsverfahren N Bilder rekonstruiert werden, wobei N > 2 gilt,
**dass** in jedem der N Bilder im Wesentlichen einer von N Stoffen abgebildet ist, so dass in jedem der N Bilder im Wesentlichen ein anderer Stoff abgebildet ist als in den anderen Bildern,
**dass** für jedes Bild eine individuelle Verschiebungslänge bestimmt wird, um welche das jeweilige Bild gegenüber einem bestimmten der Bilder aufgrund der chemischen Verschiebung entlang der Ausleserichtung verschoben ist,
**dass** jedes der Bilder gegenüber dem bestimmten Bild abhängig von seiner individuellen Verschiebungslänge entlang der Ausleserichtung verschoben wird, um die Verschiebung des jeweiligen Bildes gegenüber dem bestimmten Bild entlang der Ausleserichtung aufgrund der chemischen Verschiebung zu kompensieren, und
**dass** die N Bilder kombiniert werden, um das MR-Bild zu erzeugen.

11. Verfahren nach einem der vorhergehenden Ansprüche,
**dadurch gekennzeichnet,**
**dass** das Separationsverfahren auf der Dixon-Methode basiert.

12. Magnetresonanzanlage zur Rekonstruktion eines MR-Bildes (43) eines Volumenabschnitts innerhalb eines Untersuchungsobjekts (O),
wobei die Magnetresonanzanlage (5) einen Grundfeldmagneten (1), ein Gradientenfeldsystem (3), mindestens eine HF-Antenne (4) und eine Steuereinrichtung (10) zur Ansteuerung des Gradientenfeldsystems (3) und der mindestens einen HF-Antenne (4), zum Empfang von von der mindestens einen HF-Antenne (4) aufgenommenen Messsignalen und zur Auswertung der Messsignale und zur Rekonstruktion des MR-Bildes (43) umfasst, und
wobei die Magnetresonanzanlage (5) ausgestaltet ist,
um MR-Daten innerhalb des Volumenabschnitts gemäß einem Separationsverfahren zu erfassen, indem die Magnetresonanzanlage (5) in einem Schritt jeweils die MR-Daten einer K-Raum-Zeile erfasst während mittels des Gradientenfeldsystem (3) ein Auslesegradient ($G_x$) jeweils entlang derselben Ausleserichtung geschaltet wird, um mittels der Steuereinrichtung (10) gemäß dem Separationsverfahren aus den MR-Daten ein Bild (41) eines ersten Stoffes und ein Bild (42) eines zweiten Stoffes zu rekonstruieren,
um mittels der Steuereinrichtung (10) eine Verschiebungslänge (V), um welche das Bild (41) des ersten Stoffes und das Bild (42) des zweiten Stoffes aufgrund der chemischen Verschiebung entlang der Ausleserichtung relativ zueinander verschoben sind, zu bestimmen,
um mittels der Steuereinrichtung (10) das Bild (41) des ersten Stoffes und/oder das Bild (42) des zweiten Stoffes abhängig von der Verschiebungslänge (V) zu verschieben, um die Verschiebung des Bildes (41) des ersten Stoffes gegenüber dem Bild (42) des zweiten Stoffes entlang der Ausleserichtung aufgrund der chemischen Verschiebung zu kompensieren, und
um mittels der Steuereinrichtung (10) das Bild (41) des ersten Stoffes und das Bild (42) des zweiten Stoffes zu kombinieren, um das MR-Bild (43) zu erzeugen.

13. Magnetresonanzanlage nach Anspruch 12,
**dadurch gekennzeichnet,**
**dass** die Magnetresonanzanlage (5) zur Durchführung des Verfahrens nach einem der Ansprüche 1-11 ausgestaltet ist.

14. Computerprogrammprodukt, welches ein Programm umfasst und direkt in einen Speicher einer programmierbaren Steuereinrichtung (10) einer Magnetresonanzanlage (5) ladbar ist, mit Programm-Mitteln, um alle Schritte des Verfahrens nach einem der Ansprüche 1-11 auszuführen, wenn das Programm in der Steuereinrichtung (10) der Magnetresonanzanlage (5) ausgeführt wird.

15. Elektronisch lesbarer Datenträger mit darauf gespeicherten elektronisch lesbaren Steuerinformationen, welche derart ausgestaltet sind, dass sie bei Verwendung des Datenträgers (21) in einer Steuereinrichtung (10) einer Magnetresonanzanlage (5) das Verfahren nach einem der Ansprüche 1-11 durchführen.

FIG 1

EP 3 001 212 A1

FIG 2

44 →    31 [          ]  32 [          ]  31 [          ]

FIG 3

41 →    31 [          ]

                                          31 [          ]
                                          ⇒ V →

42 →              32 [          ]

FIG 4

                                          −V
                                          ⇐

43 →    31 [          ]  32 [          ]  31 [          ]

FIG 5

# FIG 6

```
        ┌─────────┐
        │  Start  │
        └────┬────┘
             ▼
┌───────────────────────────────────────┐
│ Erfassen von MR-Daten gemäß der Dixon-Methode. │  ～S1
└───────────────────┬───────────────────┘
                    ▼
┌───────────────────────────────────────┐
│    Rekonstruktion eines Wassersignal-Bildes    │  ～S2
│           aus den MR-Daten.            │
└───────────────────┬───────────────────┘
                    ▼
┌───────────────────────────────────────┐
│      Rekonstruktion eines Fettsignal-Bildes     │  ～S3
│           aus den MR-Daten.            │
└───────────────────┬───────────────────┘
                    ▼
┌───────────────────────────────────────┐
│  Bestimmen einer Verschiebungslänge, um welche   │
│ das Festtsignal-Bild relativ zum Wassersignal-Bild │  ～S4
│     aufgrund der chemischen Verschiebung       │
│            verschoben ist.              │
└───────────────────┬───────────────────┘
                    ▼
┌───────────────────────────────────────┐
│ Verschieben des Fettsignal-Bildes um die negative │
│   Verschiebungslänge gegenüber dem          │  ～S5
│           Wassersignal-Bild.            │
└───────────────────┬───────────────────┘
                    ▼
┌───────────────────────────────────────┐
│    Kombinieren des Wassersignal-Bildes        │  ～S6
│        und des Fettsignal-Bildes.           │
└───────────────────┬───────────────────┘
                    ▼
             ┌─────────┐
             │  Ende   │
             └─────────┘
```

Europäisches Patentamt
European Patent Office
Office européen des brevets

**EUROPÄISCHER RECHERCHENBERICHT**

Nummer der Anmeldung

EP 15 18 5225

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 373 249 B1 (KWOK WINGCHI E [US] ET AL) 16. April 2002 (2002-04-16)<br><br>* Spalte 3, Zeile 1 - Spalte 7, Zeile 16 *<br>* Abbildungen 2, 10, 11 *<br>----- | 1-3,5,6, 8-10, 12-15 | INV.<br>G01R33/48<br>G01R33/565 |
| X | US 5 446 384 A (DUMOULIN CHARLES L [US]) 29. August 1995 (1995-08-29)<br>* Spalte 4, Zeile 33 - Spalte 10, Zeile 18 *<br>* Abbildungen 2a-5 *<br>----- | 1-10, 12-15 | |
| X | US 2008/048657 A1 (REEDER SCOTT B [US]) 28. Februar 2008 (2008-02-28)<br>* Absatz [0012] - Absatz [0021] *<br>* Absatz [0041] - Absatz [0057] *<br>* Abbildungen 2-5 *<br>----- | 1-15 | |
| X | US 2007/285094 A1 (REEDER SCOTT B [US] ET AL) 13. Dezember 2007 (2007-12-13)<br>* Absatz [0024] - Absatz [0038] *<br>* Abbildungen 1, 4 *<br>----- | 1-3,5,6, 8-15 | RECHERCHIERTE SACHGEBIETE (IPC)<br><br>G01R<br>A61B<br>G01N |

Der vorliegende Recherchenbericht wurde für alle Patentansprüche erstellt

| Recherchenort | Abschlußdatum der Recherche | Prüfer |
|---|---|---|
| München | 18. Februar 2016 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 15 18 5225

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-02-2016

| Im Recherchenbericht angeführtes Patentdokument | Datum der Veröffentlichung | Mitglied(er) der Patentfamilie | Datum der Veröffentlichung |
|---|---|---|---|
| US 6373249 B1 | 16-04-2002 | KEINE | |
| US 5446384 A | 29-08-1995 | KEINE | |
| US 2008048657 A1 | 28-02-2008 | EP 2057602 A2<br>JP 5201368 B2<br>JP 2010502301 A<br>US 2008048657 A1<br>WO 2008027813 A2 | 13-05-2009<br>05-06-2013<br>28-01-2010<br>28-02-2008<br>06-03-2008 |
| US 2007285094 A1 | 13-12-2007 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **DIXON'S.** Handbook of MRI Pulse Sequences
- **L. AN ; Q. XING.** Chemical shift imaging with spectrum modeling. *Magn.Reson.Med.,* 2001, vol. 46, 126-130